# EUROPEAN PATENT SPECIFICATION

(11) **EP 4 569 548 B1**
(45) Date of publication and mention of the grant of the patent: **03.06.2026**
(21) Application number: 23765084.1
(22) Date of filing: 08.08.2023
(51) Int. Cl.: H10H 20/01, H10H 20/851, H10H 20/853, H10H 20/854

(54) **LIGHT EMITTING DEVICE WITH LIGHT-ALTERING MATERIAL LAYER, AND FABRICATION METHOD UTILIZING SEALING TEMPLATE**
LICHTEMITTIERENDE VORRICHTUNG MIT LICHTVERÄNDERNDER MATERIALSCHICHT UND HERSTELLUNGSVERFAHREN UNTER VERWENDUNG EINER DICHTUNGSVORLAGE
DISPOSITIF ÉLECTROLUMINESCENT AVEC COUCHE DE MATÉRIAU MODIFIANT LA LUMIÈRE, ET PROCÉDÉ DE FABRICATION UTILISANT UN GABARIT D'ÉTANCHÉITÉ

(30) Priority: 11.08.2022 US 202217885765
(43) Date of publication of application: 18.06.2025
(73) Proprietor: Creeled, Inc., Durham, NC 27709 (US)
(72) Inventor: ANDREWS, Peter Scott, Durham, North Carolina 27712 (US)
(74) Representative: Dehns
(86) International application number: PCT/US2023/071846
(87) International publication number: WO 2024/036152

(56) References cited:
- EP-A1- 2 919 284
- WO-A1-2019/236325
- WO-A1-2022/046459
- US-A1- 2008 074 032
- US-A1- 2011 062 469
- US-A1- 2012 305 970
- US-A1- 2016 276 546
- US-A1- 2022 052 232
- US-B2- 8 901 592

## Description

### TECHNICAL FIELD

Subject matter herein relates to solid state light-emitting devices incorporating light-altering materials arranged over one or more light emitting diodes (LEDs), and methods for fabricating such devices.

### BACKGROUND

Solid-state lighting devices such as light-emitting diodes (LEDs) are increasingly used in both consumer and commercial applications. LEDs have been widely adopted in various illumination contexts, as well as for backlighting of liquid crystal displays and for providing sequentially illuminated LED displays. Illumination applications include automotive headlamps, roadway lamps, stadium lights, light fixtures, flashlights, and various indoor, outdoor, and specialty lighting contexts. Desirable characteristics of LED devices according to various end uses include high luminous efficacy, uniform color point over an illuminated area, long lifetime, wide color gamut, and compact size.

LEDs are solid-state devices that convert electrical energy to light and generally include one or more active layers of semiconductor material (or an active region) arranged between oppositely doped n-type and p-type layers. When a bias is applied across the doped layers, holes and electrons are injected into the one or more active layers where they recombine to generate emissions such as visible light or ultraviolet emissions. An LED chip typically includes an active region that may be fabricated, for example, from silicon carbide, gallium nitride, gallium phosphide, indium phosphide, aluminum nitride, gallium arsenide-based materials, and/or from organic semiconductor materials. Photons generated by the active region are initiated in all directions.

Lumiphoric materials, such as phosphors, may be arranged in light emission paths of LED emitters to convert portions of light to different wavelengths. LED packages have been developed that can provide mechanical support, electrical connections, and encapsulation for LED emitters. Light emissions that exit surfaces of LED emitters typically interact with lumiphoric materials and various elements or surfaces of the LED package before being emitted into an environment, thereby increasing opportunities for light loss (e.g., due to internal absorption) and potential non-uniformity of light emissions. As such, there can be challenges in producing high quality light with desired emission characteristics while also providing high luminous efficacy.

The art continues to seek improved solid-state lighting devices having desirable illumination characteristics capable of overcoming challenges associated with conventional lighting devices, and methods for fabricating such devices. US 2022052232 A1, WO 2022046459 A1, US 2011062469 A1, US 8901592 B1, US 2008074032 A1, US 2012305970 A1 and US 2016276546 A1 disclose a solid state light emitting device.

### SUMMARY

In one aspect, the present invention provides a solid state light emitting device according to claim 1.

In certain embodiments, the solid state light emitting device further comprises a scattering material layer contacting lateral boundaries of the lumiphoric material layer.

In certain embodiments, the scattering material layer comprises a maximum height equal to a maximum height of the lumiphoric material layer.

In certain embodiments, the solid state light emitting device further comprises a lens material arranged in contact with the lumiphoric material layer and at least a portion of the scattering material layer.

In certain embodiments, the fill material is compositionally identical to the scattering material layer.

In certain embodiments, the peripheral portion of the lumiphoric material layer comprises a non-uniform thickness.

In certain embodiments, the solid state light emitting device further comprises a scattering material layer that (i) overlaps at least part of the peripheral portion of the lumiphoric material layer, and (ii) laterally bounds the lumiphoric material layer.

In certain embodiments, the solid state light emitting device further comprises a lens material arranged in contact with the lumiphoric material layer and overlying at least a portion of the fill material layer.

In certain embodiments, the solid state light emitting device further comprises an elevated reflector structure overlying at least a portion of the fill material layer, the elevated reflector structure defining a reflector cavity registered with the at least one LED; and a lens material arranged in the reflector cavity and in contact with the lumiphoric material layer.

In certain embodiments, the lumiphoric material layer, the fill material layer, the elevated reflector structure, and the lens material are matched in coefficient of thermal expansion (CTE), such that a difference in CTE between any two or more of the lumiphoric material layer, the fill material layer, the elevated reflector structure, and the lens material is in a range of less than 20%, less than 15%, less than 10%, less than 5%, or less than 2%. Providing CTE matching between such components enhances durability when a lighting device is subjected numerous operating cycles, particularly in view of high operating temperatures of LED chips.

In another aspect, the present invention provides a method for fabricating at least one solid state light emitting device according to claim 9.

In certain embodiments, the light-altering material comprises scattering material.

In certain embodiments, the sealing template comprises an ultraviolet release adhesive layer and a carrier, and the method further comprises impinging ultraviolet emissions on the sealing template to reduce a tack of the ultraviolet release adhesive layer prior to said removing of the sealing template from the fill material.

The fill material comprises white or reflective particles within a binder (such as, but not limited to, TiO₂ particles in a silicone binder).

In certain embodiments, the fill material comprises a removable material and the method further comprises removing the fill material after the removing of the sealing template from the fill material.

In certain embodiments, the fill material is applied over the first surface of the submount by at least one process selected from the group consisting of (a) jet pumping, (b) stencil printing, (c) screen printing, (d) dispensing, and (e) spraying.

In certain embodiments, an area of at least one window is larger than an area of the outer surface of the at least one LED; and the applying of the light-altering material through the at least one window to the outer surface of the at least one LED causes a portion of the light-altering material to contact the fill material in a region outside a perimeter of the outer surface of the at least one LED.

In certain embodiments, the sealing template is applied over an intermediate layer that is elevated relative to the fill material; and the light-altering material is applied through the at least one window to the outer surface of the at least one LED by spraying.

In certain embodiments, the light-altering material is applied to the outer surface of the at least one LED to provide a light-altering material layer thickness that varies with position along the outer surface of the at least one LED.

In certain embodiments, the method further comprises applying a transparent material layer over the sealing template prior to and/or after said applying of the light-altering material through the at least one window to the outer surface of the at least one LED.

In certain embodiments, the method further comprises, after the removing of the sealing template, applying a light-scattering or light-absorbing material layer over the fill material to contact lateral boundaries of the light-altering material layer.

In another aspect, any of the foregoing aspects, and/or various separate aspects and features as described herein, may be combined for additional advantage. Any of the various features and elements as disclosed herein may be combined with one or more other disclosed features and elements unless indicated to the contrary herein.

Other aspects, features and embodiments of the present invention will be more fully apparent from the ensuing detailed description and appended claims.

### BRIEF DESCRIPTION OF THE DRAWINGS

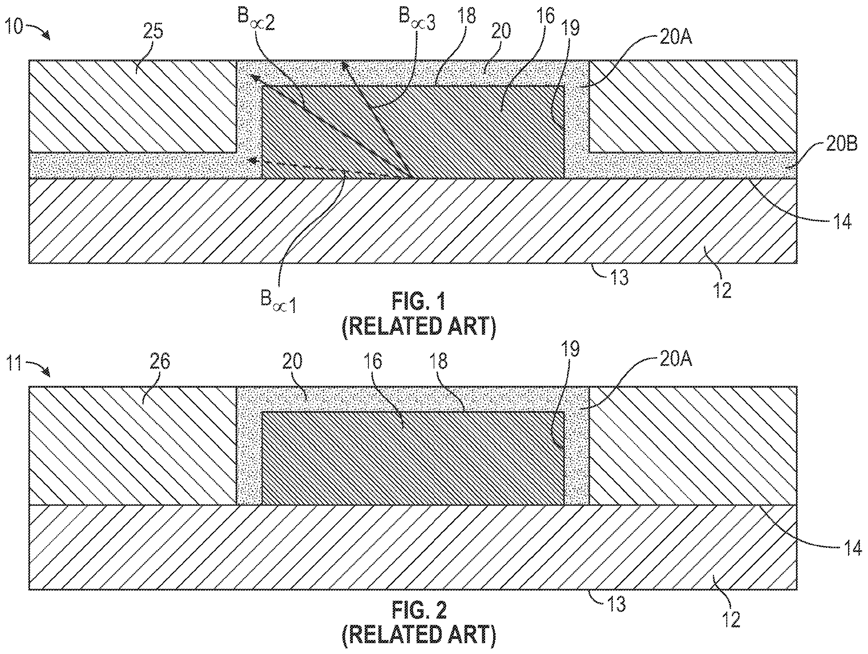

FIG. 1 is a simplified cross-sectional view of a first conventional solid state light emitting device including a LED chip supported by a submount, with a lumiphoric material layer covering upper surfaces of the LED chip and the submount, and covering side surfaces of the LED chip, with reflective material arranged on portions of the lumiphoric material layer, and with superimposed arrows showing selected light beams emanating from a center of the LED chip.
FIG. 2 is a simplified cross-sectional view of a second conventional solid state light emitting device including a LED chip supported by a submount, with a lumiphoric material layer covering upper and side surfaces of the LED chip, and with reflective material arranged on the submount and side surface portions of the lumiphoric material layer.

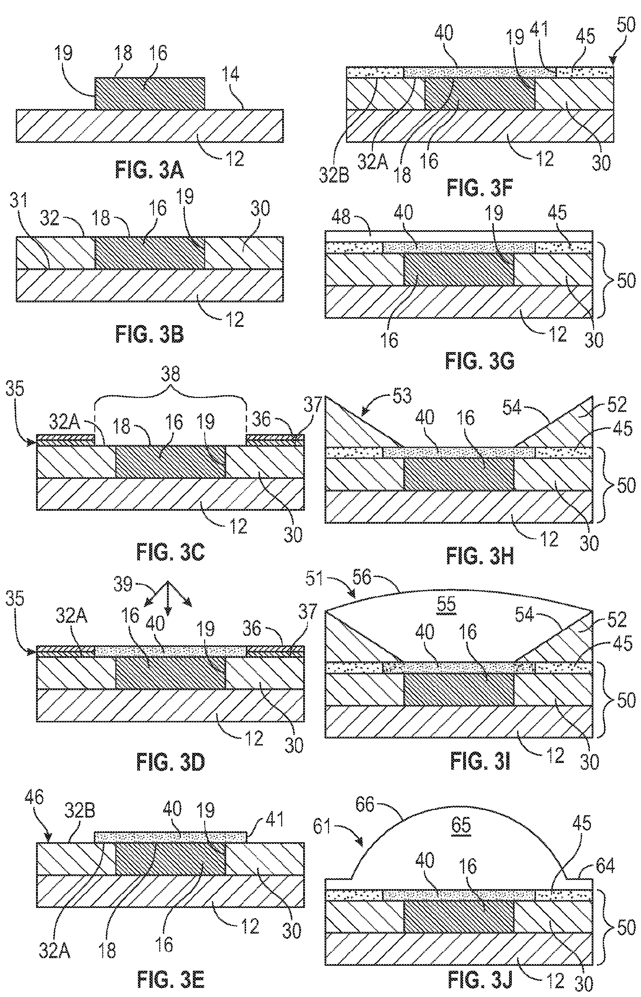

FIGS. 3A-3F are simplified cross-sectional views depicting steps utilizing a sealing template in producing at least a portion of solid state light emitting device (or subassembly) according to examples not forming part of the present invention, the device portion having a light-altering (e.g., lumiphoric) material layer arranged over an upper surface of a LED chip supported by a submount and over portions of a first fill material layer that contacts lateral edges of the LED chip, with a second fill material layer contacting lateral edges of the lumiphoric material layer.
FIG. 3G is a simplified ross-sectional view of the device portion or subassembly of FIG. 3F following additional of an optional clear material layer over the light-altering material and fill material.
FIGS. 3H-3I are simplified cross-sectional views depicting further steps in producing a solid state light emitting device incorporating the device portion of FIG. 3F including formation of a cavity-defining elevated reflector structure arranged over the second fill material layer, and formation of a lens material having an outwardly curved shape contacting the lumiphoric material layer and walls of the elevated reflector structure.
FIG. 3J is a simplified cross-sectional view depicting a further step in producing a solid state light emitting device incorporating the device portion of FIG. 3F, including formation of a lens material having an outwardly curved shape contacting the lumiphoric material layer and portions of the second fill material layer.

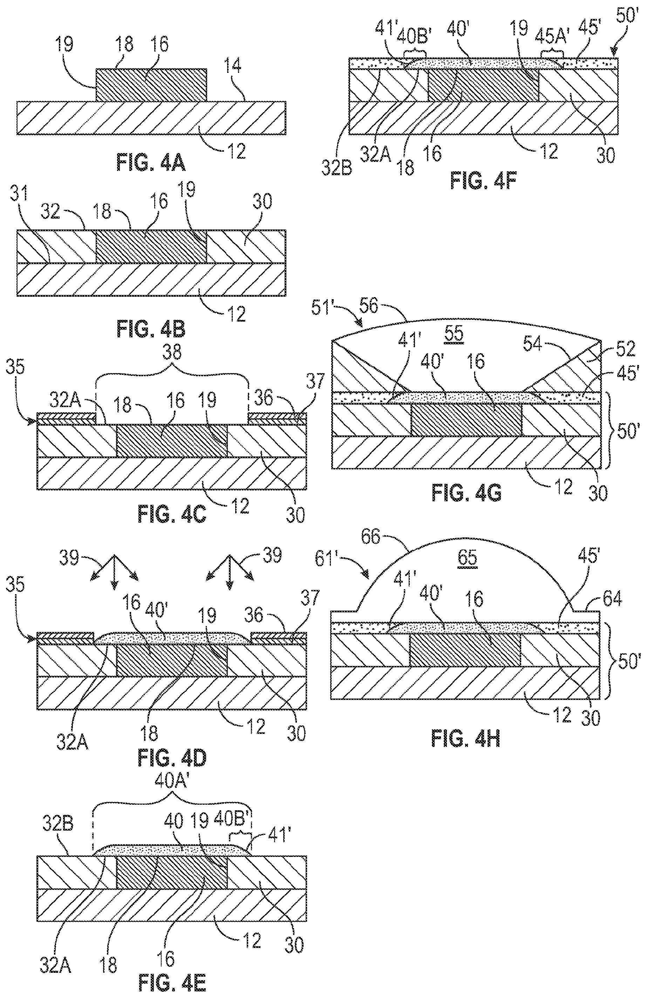

FIGS. 4A-4F are simplified cross-sectional views depicting steps utilizing a sealing template in producing at least a portion of solid state light emitting device according to embodiments of the present invention, the device portion having a lumiphoric material layer (or other light-altering material layer) arranged over an upper surface of a LED chip supported by a submount and over portions of a first fill material layer that contacts lateral edges of the LED chip, with a second fill material layer contacting lateral edges of the lumiphoric material layer, wherein peripheral portions of the lumiphoric material have a reduced thickness relative to a central portion thereof, and portions of the second fill material layer overlap peripheral portions of the lumiphoric material layer.
FIG. 4G is a simplified cross-sectional view of a solid state light emitting device incorporating the device portion of FIG. 4F, following formation of a cavity-defining elevated reflector structure arranged over the second fill material layer, and formation of a lens material having an outwardly curved shape contacting the lumiphoric material layer and walls of the elevated reflector structure.
FIG. 4H is a simplified cross-sectional view of a solid state light emitting device incorporating the device portion of FIG. 4F, following formation of a lens material having an outwardly curved shape contacting the lumiphoric material layer and portions of the second fill material layer.

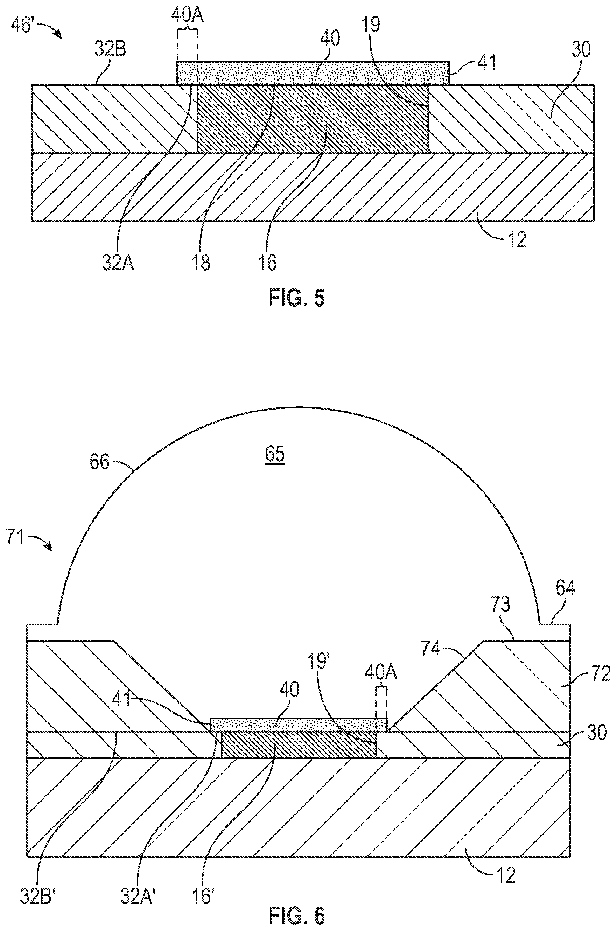

FIG. 5 is a simplified cross-sectional view of at least a portion of a solid state light emitting device according to an example not forming part of the present invention, including a lumiphoric material layer arranged over an upper surface of a LED chip and over portions of a first fill material layer that contacts lateral edges of the LED chip.
FIG. 6 is a simplified cross-sectional view of a solid state light emitting device according to an example not forming part of the present invention, including a cavity-defining elevated reflector structure arranged over a first fill material layer, and lens material having a substantially hemispherical shape contacting walls of the elevated reflector structure and contacting a lumiphoric material layer arranged over a LED chip.

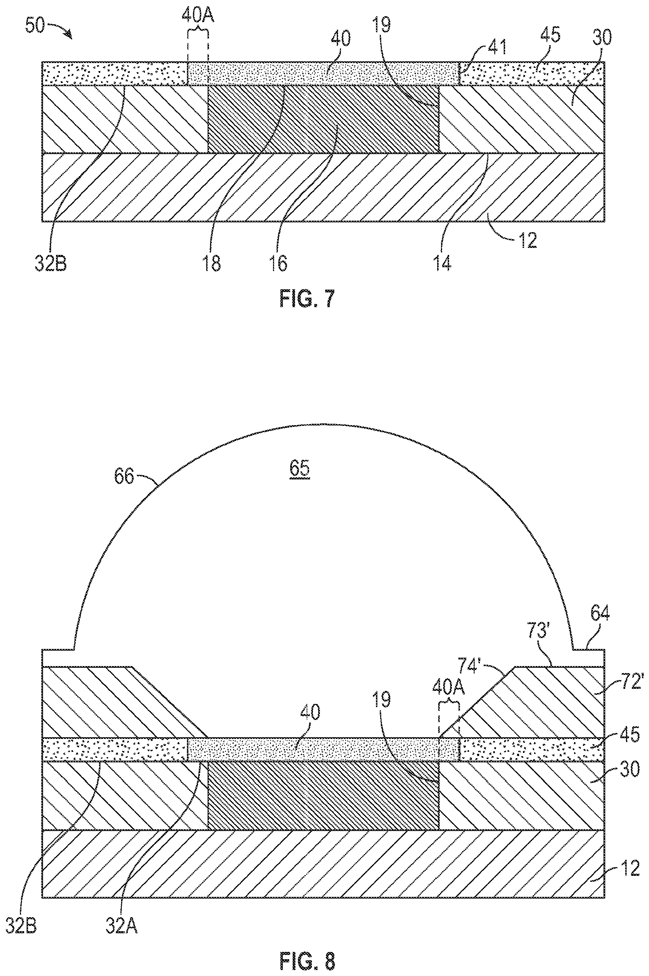

FIG. 7 provides a magnified cross-sectional view of the solid state light emitting device portion of FIG. 3F, in which a lumiphoric material layer is arranged over an upper surface of a LED chip and over portions of a first fill material layer that contacts lateral edges of the LED chip, and including a second fill material that contacts lateral edges of the lumiphoric material layer.
FIG. 8 is a simplified cross-sectional view of a solid state light emitting device according to an example not forming part of the present invention, incorporating the device portion of FIG. 7, including a cavity-defining elevated reflector structure arranged over the second fill material layer, and lens material having a substantially hemispherical shape contacting walls of the elevated reflector structure and contacting the lumiphoric material layer.

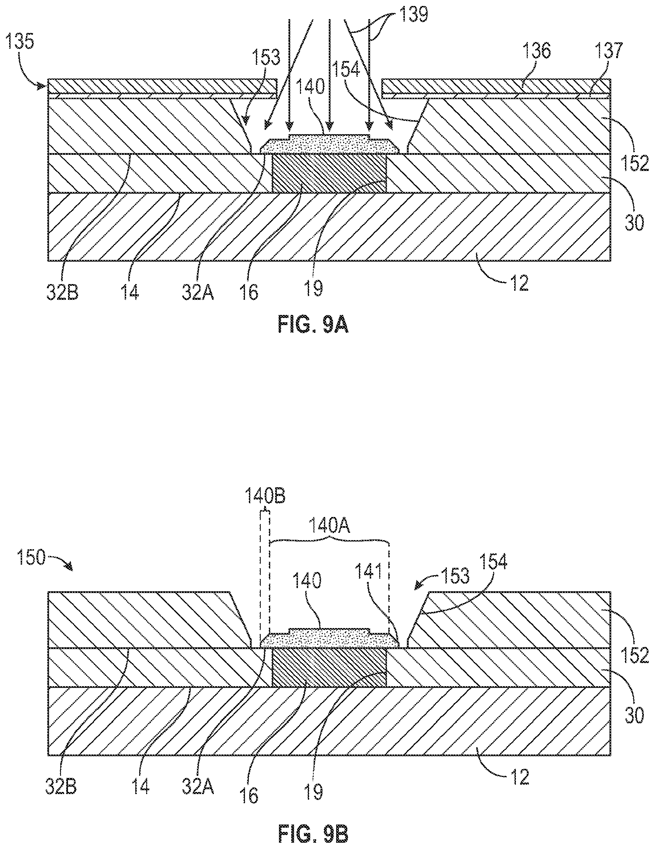

FIG. 9A is a simplified cross-sectional view of a solid state light emitting device including a LED chip supported by a submount and arranged in a cavity defined by an elevated reflector structure, showing the application of lumiphoric material having a non-uniform thickness onto the LED chip through a window defined in sealing template arranged over the elevated reflector structure.
FIG. 9B is a cross-sectional view of the solid state light emitting device of FIG. 9A, following removal of the sealing template.

### DETAILED DESCRIPTION

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the present invention as defined by the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

Before delving into specific details of various aspects of the present disclosure, an overview of various elements that may be included in exemplary LEDs of the present disclosure is provided for context. A LED chip typically comprises an active LED structure or region that can have many different semiconductor layers arranged in different ways. The fabrication and operation of LEDs and their active structures are generally known in the art and are only briefly discussed herein. The layers of the active LED structure can be fabricated using known processes with a suitable process being fabrication using metal organic chemical vapor deposition. The layers of the active LED structure can comprise many different layers and generally comprise an active layer sandwiched between n-type and p-type oppositely doped epitaxial layers, all of which are formed successively on a growth substrate. It is understood that additional layers and elements can also be included in the active LED structure, including, but not limited to, buffer layers, nucleation layers, super lattice structures, undoped layers, cladding layers, contact layers, and current-spreading layers and light extraction layers and elements. The active layer can comprise a single quantum well, a multiple quantum well, a double heterostructure, or super lattice structures.

The active LED structure can be fabricated from different material systems, with some material systems being Group III nitride-based material systems. Group III nitrides refer to those semiconductor compounds formed between nitrogen (N) and the elements in Group III of the periodic table, usually aluminum (Al), gallium (Ga), and indium (In). Gallium nitride (GaN) is a common binary compound. Group III nitrides also refer to ternary and quaternary compounds such as aluminum gallium nitride (AlGaN), indium gallium nitride (InGaN), and aluminum indium gallium nitride (AlInGaN). For Group III nitrides, silicon (Si) is a common n-type dopant and magnesium (Mg) is a common p-type dopant. Accordingly, the active layer, n-type layer, and p-type layer may include one or more layers of GaN, AlGaN, InGaN, and AlInGaN that are either undoped or doped with Si or Mg for a material system based on Group III nitrides. Other material systems include silicon carbide (SiC), organic semiconductor materials, and other Group III-V systems such as gallium phosphide (GaP), gallium arsenide (GaAs), indium phosphide (InP), and related compounds.

The active LED structure may be grown on a growth substrate that can include many materials, such as sapphire, SiC, aluminum nitride (AIN), GaN, GaAs, glass, or silicon. SiC has certain advantages, such as a closer crystal lattice match to Group III nitrides than other substrates and results in Group III nitride films of high quality. SiC also has a very high thermal conductivity so that the total output power of Group III nitride devices on SiC is not limited by the thermal dissipation of the substrate. Sapphire is another common substrate for Group III nitrides and also has certain advantages, including being lower cost, having established manufacturing processes, and having good light-transmissive optical properties.

Different embodiments of the active LED structure can emit different wavelengths of light depending on the composition of the active layer and n-type and p-type layers. In some embodiments, the active LED structure emits blue light with a peak wavelength range of approximately 430 nanometers (nm) to 480 nm. In other embodiments, the active LED structure emits green light with a peak wavelength range of 500 nm to 570 nm. In other embodiments, the active LED structure emits red light with a peak wavelength range of 600 nm to 650 nm. In certain embodiments, the active LED structure may be configured to emit light that is outside the visible spectrum, including one or more portions of the ultraviolet (UV) spectrum.

A LED chip can also be covered with one or more lumiphoric materials (also referred to herein as lumiphors), such as phosphors, such that at least some of the light from the LED chip is absorbed by the one or more lumiphors and is converted to one or more different wavelength spectra according to the characteristic emission from the one or more lumiphors. In this regard, at least one lumiphor receiving at least a portion of the light generated by the LED source may re-emit light having different peak wavelength than the LED source. A LED source and one or more lumiphoric materials may be selected such that their combined output results in light with one or more desired characteristics such as color, color point, intensity, spectral density, etc. In certain embodiments, aggregate emissions of LED chips, optionally in combination with one or more lumiphoric materials, may be arranged to provide cool white, neutral white, or warm white light, such as within a color temperature range of 2500 Kelvin (K) to 10,000 K. In certain embodiments, lumiphoric materials having cyan, green, amber, yellow, orange, and/or red peak wavelengths may be used. In certain embodiments, the combination of the LED chip and the one or more lumiphors (e.g., phosphors) emits a generally white combination of light. The one or more phosphors may include yellow (e.g., YAG:Ce), green (e.g., LuAg:Ce), and red (e.g., Ca_{i-x-y}SrₓEu_{y}AlSiN₃) emitting phosphors, and combinations thereof. In other embodiments, the LED chip and corresponding lumiphoric material may be configured to primarily emit converted light from the lumiphoric material so that aggregate emissions include little to no perceivable emissions that correspond to the LED chip itself.

Lumiphoric materials as described herein may be or include one or more of a phosphor, a scintillator, a lumiphoric ink, a quantum dot material, a day glow tape, and the like. Lumiphoric materials may be provided by any suitable means, for example, direct coating on one or more surfaces of an LED, dispersal in an encapsulant material configured to cover one or more LEDs, and/or coating on one or more optical or support elements (e.g., by powder coating, inkjet printing, or the like). In certain embodiments, lumiphoric materials may be downconverting or upconverting, and combinations of both downconverting and upconverting materials may be provided. In certain embodiments, multiple different (e.g., compositionally different) lumiphoric materials arranged to produce different peak wavelengths may be arranged to receive emissions from one or more LED chips. One or more lumiphoric materials may be provided on one or more portions of an LED chip in various configurations. In certain embodiments, one or more lumiphoric materials may be arranged on or over one or more surfaces of an LED chip in a substantially uniform manner. In other embodiments, one or more lumiphoric materials may be arranged on or over one or more surfaces of an LED chip in a manner that is non-uniform with respect to one or more of material composition, concentration, and thickness. In certain embodiments, the loading percentage of one or more lumiphoric materials may be varied on or among one or more outer surfaces of an LED chip. In certain embodiments, one or more lumiphoric materials may be patterned on portions of one or more surfaces of an LED chip to include one or more stripes, dots, curves, or polygonal shapes. In certain embodiments, multiple lumiphoric materials may be arranged in different discrete regions or discrete layers on or over an LED chip.

As used herein, a layer or region of a light-emitting device may be considered to be "transparent" when at least 80% of emitted radiation that impinges on the layer or region emerges through the layer or region. Moreover, as used herein, a layer or region of an LED is considered to be "reflective" or embody a "mirror" or a "reflector" when at least 80% of the emitted radiation that impinges on the layer or region is reflected. In some embodiments, the emitted radiation comprises visible light such as blue and/or green LEDs with or without lumiphoric materials. In other embodiments, the emitted radiation may comprise nonvisible light. For example, in the context of GaN-based blue and/or green LEDs, silver (Ag) may be considered a reflective material (e.g., at least 80% reflective). In the case UV LEDs, appropriate materials may be selected to provide a desired, and in some embodiments high, reflectivity and/or a desired, and in some embodiments low, absorption. In certain embodiments, a "light-transmissive" material may be configured to transmit at least 50% of emitted radiation of a desired wavelength.

LED packages may include one or more elements, such as lumiphoric materials and electrical contacts, among others, that are provided with one or more LED chips on a support member, such as a submount or a lead frame. Suitable materials for the submount include, but are not limited to, ceramic materials such as aluminum oxide or alumina, AIN, or organic insulators like polyimide (PI) and polyphthalamide (PPA). In other embodiments, a submount may comprise a printed circuit board (PCB), sapphire, Si or any other suitable material. For PCB embodiments, different PCB types can be used such as standard FR-4 PCB, metal core PCB, or any other type of PCB. In still further embodiments, the support structure may embody a lead frame structure. Light-altering materials may be arranged within LED packages to reflect or otherwise redirect light from the one or more LED chips in a desired emission direction or pattern.

As used herein, "light-altering materials" may include many different materials including light-reflective materials that reflect or redirect light, that scatter light, light-absorbing materials that absorb light, lumiphoric materials, and materials that act as a thixotropic agent. As used herein, the term "light-reflective" refers to materials or particles that reflect, refract, scatter, or otherwise redirect light. For light-reflective materials, the light-altering material may include at least one of fused silica, fumed silica, titanium dioxide (TiO₂), or metal particles suspended in a binder, such as silicone or epoxy. In certain aspects, the particles may have an index or refraction that is configured to refract light emissions in a desired direction. In certain aspects, light-reflective particles may also be referred to as light-scattering particles. A weight ratio of the light-reflective particles or scattering particles to a binder may comprise a range of about 0.15:1 to about 0.5:1, or in a range of about 0.5:1 to about 1:1, or in a range of about 1:1 to about 2:1, depending on a desired viscosity before curing. For light-absorbing materials, the light-altering material may include at least one of carbon, silicon, or metal particles suspended in a binder, such as silicone or epoxy. The light-reflective materials and the light-absorbing materials may comprise nanoparticles. In certain embodiments, the light-altering material may comprise a generally white color to reflect and redirect light. In other embodiments, the light-altering material may comprise a generally opaque color, such as black or gray for absorbing light and increasing contrast. In certain embodiments, the light-altering material includes both light-reflective material and light-absorbing material suspended in a binder.

Solid state light emitting devices disclosed herein according to various embodiments include at least one LED mounted over a submount having a first surface, a lumiphoric material layer applied over an entirety of an outer surface of the at least one LED that is distal from the first surface, wherein lateral edges of the at least one LED are devoid of a lumiphoric material, and a fill material layer contacting lateral surfaces of the at least one LED, and optionally a scattering material layer contacting lateral boundaries of the light-altering material layer when the light-altering material layer comprises a lumiphoric material. Methods for fabricating at least one solid state light emitting device comprise applying a fill material layer to contact lateral surfaces of at least one LED mounted on a submount, adhering a sealing template on or over the fill material, and applying a light-altering material (e.g., a lumiphoric material and/or a light scattering material) through a window defined in the sealing template to form a light-altering material layer on the at least one LED, and removing the sealing template from the fill material.

Solid state light emitting devices disclosed herein according to various embodiments include at least one LED mounted over a submount having a first surface, a light-altering material (e.g., a lumiphoric material) layer applied over an entirety of an outer surface of the at least one LED that is distal from the first surface, wherein lateral edges of the at least one LED are devoid of a lumiphoric material (or the light-altering material layer), and a fill material layer contacting lateral surfaces of the at least one LED, and optionally a scattering material layer contacting lateral boundaries of the light-altering material layer when the light-altering material layer comprises a lumiphoric material. Methods for fabricating at least one light emitting device comprise applying a fill material layer to contact lateral surfaces of at least one LED mounted on a submount, adhering a sealing template on or over the fill material, and applying a light-altering material (comprising a lumiphoric material) through a window defined in the sealing template to form a light-altering material layer on the at least one LED, and removing the sealing template from the fill material.

Prior templates have been used or tested by the Applicant to seek to confine the deposition of light-altering materials (e.g., lumiphoric materials such as phosphors) to selected areas of one or more light emitting device precursors, but such templates have suffered from various shortcomings that limited their utility. Such templates include stencil templates, three-dimensionally printed templates, and the like. Such templates did not provide satisfactory results because they either allowed light-altering material to pass between the template and underlying layer(s), or they would tend to cause light-altering material to stick to template walls, leading to poor control of areas where light-altering material would remain on underlying layer(s). For example, a conventional screen printing process for phosphor deposition utilizes a screen template that cannot seal well on a non-flat underlying surface (such as a substrate with numerous light emitting diodes and electrostatic discharge diodes mounted thereon), and requires significant downward force, resulting in migration of phosphor particles under the screen template. As another example, spraying of a phosphor composition through windows defined in a non-sealed template tends to result in phosphor particles migrating under the template. However, local deposition of phosphor material over a LEDs arranged on a substrate without use of a template is also difficult, since a surface effects (e.g., surface tension tending to lead to meniscus formation) tend to prevent phosphor mixtures from covering entire emitting areas of LED (including corners thereof), and/or tend to form domed phosphor deposits with uneven thickness (i.e., having a thickness greater in a center of a LED chip than proximate to edges thereof).

In certain embodiments, a sealing template comprises a carrier layer (e.g., a film) and an adhesive layer, which may be provided in the form of an adhesive tape. In certain embodiments, the carrier layer be configured to transmit ultraviolet (UV) spectrum emissions, and the adhesive layer may comprise a UV release adhesive that exhibits a reduction or loss of tack upon exposure of the adhesive to UV spectrum emissions. One or more windows may be defined in the sealing template by any suitable method, such as laser cutting, blade cutting, stamping, pressing, or the like.

In certain embodiments, a window-defining template may be applied to an underlying layer (e.g., with windows in the template registered with one or more LEDs supported by the underlying layer) by pressing with sufficient force to cause the adhesive layer to engage the underlying layer. Thereafter, light-altering material (e.g., lumiphoric material and/or scattering material in certain embodiments) may be applied through the windows (e.g., by spraying, dispensing, jet pumping, or other deposition methods). In certain embodiments, a sealing template may comprise a thickness substantially equal to a desired deposition thickness of the light-altering material. Optionally, any excess thickness of light-altering material may be removed by dragging a skimming member (e.g., a silicone or rubber blade, such as a squeegee) across an outer surface of the sealing template.

After deposition of the light-altering material, the template may be exposed to UV emissions to cause an adhesive layer of the template to exhibit reduced tack. Thereafter, the template may be removed from the underlying layer by pulling (e.g., from an edge thereof), to cause light-altering material previously deposited through windows in the template to remain on a target surface after the template is removed. The ability to reduce tack of an adhesive layer after material deposition is complete enables a sealing template to be cleanly released from an underlying layer, without leaving adhesive residue, and without causing unintended removal of light-altering material that otherwise would be laterally adhered to edges of windows of the sealing template. Methods disclosed herein permit clean and complete application of light-altering material solely in intended locations, without deposition of light-altering material in unintended locations, and without leaving residue on underlying surfaces. When the light-altering material comprises lumiphoric material, providing lumiphoric material solely in intended areas promotes attainment of uniform color point over an entire emissive area, and may improve brightness level and/or uniformity. In certain embodiments, multiple light-altering(e.g., lumiphoric) material layers may be applied in sequence, in the same (overlapping) are or different (non-overlapping) areas, including through a single window of a sealing template or through different windows defined in a multi-window sealing template.

To provide context for embodiments described herein, conventional solid state light emitting devices will be described in conjunction with FIGS. 1 and 2, before embodiments of the present disclosure are described in connection with the remaining figures.

FIG. 1 is a simplified cross-sectional view of a first conventional solid state light emitting device 10 including a LED chip 16 supported by a submount 12, with a first lumiphoric material layer portion 20 contacting a top or outer surface 18 of the LED chip 16, wherein a second lumiphoric layer portion 20A contacts lateral edge surfaces 19 of the LED chip 16, and a third lumiphoric layer portion 20B contacts portions of a first (upper) surface 14 of the submount 12 that extend away from the LED chip 16. During fabrication of the device 10, lumiphoric material may be applied over outer and lateral edge surfaces 18, 19 of the LED chip 16 and over the submount 12 before a reflective material 25 is provided. The submount 12 (which may embody a substrate) includes a second (lower) surface 13 that opposes the first surface 14 contacting the LED chip 16. The reflective material 25 is arranged laterally adjacent to the LED chip 16 in contact with the second lumiphoric layer portion 20A and the third lumiphoric layer portion 20B. While it is to be appreciated that light is generally emitted in all directions from the LED chip 16, three light beams (i.e., B_{α1}, B_{α2}, and B_{α3}) emanating from a center point of the LED chip at low, medium, and high emission angles α1, α2, and α3, respectively, are shown in FIG. 1. A light beam B_{α1} having a low emission angle α1 may be wavelength converted in the third lumiphoric layer portion 20B and trapped between the submount 14 and the third lumiphoric layer portion 20B without exiting the light emitting device 10. A light beam B_{α2} having a medium emission angle α2 may be wavelength converted in the second lumiphoric layer portion 20A and reflected by the reflective material 25 either back to the LED 16 or outward through the first lumiphoric layer portion 20. A light beam B_{α3} having a high emission angle α3 may be wavelength converted in the first lumiphoric layer portion 20 and exit the light emitting device 10, wherein the first lumiphoric layer portion 20 defines a light emitting surface of the device 10.

FIG. 2 is a simplified cross-sectional view of a second conventional solid state light emitting device 11 including a LED chip 16 supported by a submount 12, with a first lumiphoric material layer portion 20 contacting a top or outer surface 18 of the LED chip 16, and with a second lumiphoric layer portion 20A contacting lateral edge surfaces 19 of the LED chip 16. The submount 12 (which may embody a substrate) includes a second (lower) surface 13 that opposes the first surface 14 of the submount 12 in contact with the LED chip 16. A reflective material 25 is arranged laterally adjacent to the LED chip 16 in contact with the second lumiphoric layer portion 20A and the portions of the upper surface. The absence of lumiphoric material between the submount 12 and the reflective material 25 eliminates the trapping of photons between the submount 12 and the reflective material 2 (thereby improving luminous efficacy of the solid state light emitting device 11 relative to the device 10 illustrated in FIG. 1), but presence of the second lumiphoric material portion 20A still results in sub-optimal luminous efficacy.

In a departure from the conventional light emitting devices 10, 11 described in connection with FIGS. 1 and 2, solid state light emitting devices according to various embodiments of the present disclosure include lumiphoric material deposited over a top surface of a LED chip, with side surfaces of the LED chip contacting reflective material and being devoid of lumiphoric material. Methods disclosed herein utilizing a sealing template for applying light-altering material (such as a lumiphoric material and/or a light scattering material) are well-suited for producing such solid state light emitting devices.

FIGS. 3A-3F are simplified cross-sectional views depicting steps utilizing a sealing template in producing at least a portion of solid state light emitting device according to examples not forming part of the present invention.

FIG. 3A illustrates a LED chip 16 mounted on a first (upper) surface 14 of a submount 12, with the LED chip 16 having a top or outer surface 18 (arranged distal from the first surface 14 of the submount 12) and having lateral edge surfaces 19. In certain embodiments, the LED chip 16 may have a flip-chip configuration, wherein mounting of the LED chip 16 to the first surface 14 of the submount may involve making electrical connections between anode and cathode contacts (not shown) of the LED chip 16 and contact pads (not shown) of the submount 12.

FIG. 3B shows the items of FIG. 3A following addition of a layer of fill material 30 over the submount 12 to contact lateral edge surfaces 19 of the LED chip 16, with the top or outer surface 18 of the LED chip 16 remaining exposed. The fill material 30 comprises a reflective material, such as white (e.g., titanium dioxide or TiO₂) particles contained in a silicone binder. The fill material layer 30 may be applied by any suitable method(s), such as jet pumping, screen printing, dispensing, spraying or the like, optionally followed by a skimming step (e.g., using a rubber blade or squeegee) to remove excess thickness of fill material. In certain embodiments, the fill material layer 30 includes a lower boundary 31 contacting the submount 12 and includes an upper boundary 32 arranged at substantially the same height or level as the top surface 18 of the LED chip 16. In certain embodiments, one or more secondary components (e.g., electrostatic discharge diodes) (not shown) having a lower height than the LED chip 16 may also be supported by the submount 12, and may be encapsulated in the fill material layer 30. As shown in FIG. 3B, in certain embodiments, the upper boundary 32 of the fill material 30 may be substantially coplanar with the exposed outer surface 18 of the LED chip 16 to yield a continuous flat surface.

FIG. 3C shows the items of FIG. 3B following addition of a sealing template 35, which includes a carrier layer 36 and an adhesive layer 37, over the fill material layer 30. The sealing template 35 may be applied by pressing using a flat member and/or one or more rollers (not shown). The sealing template 35 defines a window 38 (e.g., a precut window) that is larger than but generally aligned with the LED chip 16, wherein the window 38 also overlaps an LED-adjacent portion 32A of the fill material layer 30. In certain embodiments, the carrier layer 36 comprises a material that is transmissive of UV-spectrum emissions, and the adhesive layer 37 comprises a UV-release adhesive material. The top or outer surface 18 of the LED chip 16 is exposed through the window 38 defined in the sealing template 35.

FIG. 3D shows the items of FIG. 3C following application (using a deposition apparatus 39) of a light-altering material layer 40 (e.g., lumiphoric material) through the window defined in the template 35 to be deposited on the top or outer surface 18 of the LED chip 16. As shown, the light-altering material layer 40 is arranged over the entire outer surface 18 of the LED chip and also overlaps the LED-adjacent top surface portion 32A of the fill material layer 30, so that the light-altering material layer 40 is wider than the top or outer surface 18 of the LED chip 16. Providing a light-altering material layer 40 that is wider than the top or outer surface 18 of the LED chip 16 ensures that no portions of emissions of the LED chip 16 (including from upper corners thereof) escape without interacting with the light-altering material layer 40. The light-altering material layer 40 comprises a lumiphoric material, this may enhance uniformity color point of resulting emissions over an emissive area of a solid state light-emitting device. In certain embodiments, the light affecting material layer 40 comprises lumiphoric material in a silicone binder. Any suitable method may be used to apply the light-altering material layer 40, such as spraying, dispensing, jet pumping, and the like. Optionally, any excess thickness of light-altering material 40 may be removed by dragging a skimming member (not shown) across the carrier layer 36 of the sealing template 35. Following application of the light-altering material 40, such material may be cured and solidified, such as with heat, electromagnetic radiation, and/or other means.

Although only a single light-altering material layer 40 is shown, it is to be appreciated that multiple light-altering (e.g., lumiphoric) material layers may be applied in sequence, in the same (overlapping) are or different (non-overlapping) areas, including through a single window of a sealing template or through different windows defined in a multi-window sealing template.

After (or during) the curing of the light-altering material, UV emissions may be impinged on the sealing template 35 in order to reduce a tack of the adhesive layer 37. Thereafter, the sealing template 35 may be removed from the fill material 30 (e.g., by mechanical pulling). Reduction of tack of the adhesive layer 37 prior to removal of the sealing template 35 beneficially reduced a likelihood of adhesive residue remaining on the underlying fill material 30, and also reduces a likelihood that light-altering material 40 will remain adhered laterally to boundaries of the window 38 defined in the sealing template 35, so that portions of light-altering material 40 will not be removed when the sealing template 35 is removed from the underlying fill material 30, and a clean lateral edge 41 of the light-altering material 40 remains. FIG. 3E shows the items of FIG. 3D following removal of the sealing template 35, wherein the light-altering material overlaps the entire top or outer surface 18 of the LED chip 16 as well as LED-adjacent top surface portions 32A of the fill material layer 30, while remaining top surface portions 32B of the fill material layer 30 are exposed. As shown, lateral edge surfaces 19 of the LED chip 16 are fully covered with the fill material 30 and devoid of lumiphoric material, and no lumiphoric material is provided between the fill material 30 and the submount 12.

FIG. 3F shows the items of FIG. 3E, following addition of a second fill material layer 45 to contact lateral edges 41 of the light-altering material 40 (which overlaps the outer surface 18 of the LED chip 16 and LED-adjacent top surface portions of the fill material layer 30) to contact the remaining top surface portions 32B of the fill material layer 30, to produce a solid state light-emitting device portion or subassembly 50. In certain embodiments, the second fill material layer 45 comprises a scattering material (such as fumed silica particles in a silicone binder) or a reflective material (e.g., titanium dioxide in a silicone binder). In certain embodiments, the second material layer 45 comprises a height that is substantially identical to that of the light-altering material layer 40. In certain embodiments, the second fill material layer 45 comprises substantially the same composition as the (first) fill material layer 30. In certain embodiments, the second fill material layer 45 and the fill material layer 30 each comprise reflective material in a binder, wherein the fill material layers 30, 45 may have the same or different reflectivity values. In certain embodiments, second fill material layer 45 comprises a scattering material in a binder (e.g., silicone) and the fill material layer 30 comprises a reflective material in a binder (e.g., silicone). The second fill material layer 45 may serve to scatter and/or reflect light that escapes through lateral boundaries 41 of the light-altering material layer 40, such that in certain embodiments a desirable beam cutoff pattern and/or improved luminous efficacy may be provided. The solid state light-emitting subassembly 50 is suitable for forming of various solid state light-emitting devices that may include lenses contacting the light-altering layer (with or without an optional clear layer therebetween), wherein such lens may be optionally retained in reflector cavities of various sizes and shapes.

With continued reference to FIG. 3F, in certain embodiments, the submount 12 comprises a ceramic material, the LED chip 16 comprises semiconductor materials (e.g., III-nitride materials on a sapphire or silicon carbide substrate), and the remaining layers of the solid state light emitting subassembly 50 (including the fill material layer 30, the light-altering material layer 40, and the second fill material layer 45) are substantially matched in coefficient of thermal expansion (CTE) properties, wherein "substantial matching" of CTE properties may embody inter-layer CTE differences of less than 20%, less than 15%, less than 10%, less than 5%, or less than 2% In certain embodiments, fill material layer 30, the light-altering material layer 40, and the second fill material layer 45 may comprise the same binder (e.g., silicone), loaded with particles of the same or different composition, and with the same or different concentration.

Optionally, in certain embodiments a clear (transparent) layer may be provided over the second fill material layer 45 and the light-altering material layer 40. One illustration of such an embodiment is shown in FIG. 3G, which shows the solid state light-emitting subassembly 50 with addition of a clear layer 48 over the second fill material layer 45 and the light-altering material layer 40. In certain embodiments, the clear layer 48 may comprise silicone.

FIG. 3H shows the solid state light-emitting subassembly 50 of FIG. 3F following formation of an elevated reflector structure 52 over the scattering material layer 45. The elevated reflector structure 52 includes an inclined reflector wall 54 that bounds a reflector cavity 53. In certain embodiments, the elevated reflector structure 52 comprises reflective particles (e.g., titanium dioxide) in a silicone binder. In certain embodiments, a portion of the elevated reflector structure 52 may overlap peripheral portions of the light-altering material layer 40, preferably without overlapping the LED chip 16.

FIG. 3I shows a solid state light emitting device 51 including the items of FIG. 3H (i.e., the solid state light-emitting subassembly 50 and elevated reflector structure 52), following addition of a lens material 55 to the reflector cavity 53 to contact the angled reflector wall 54. As shown, the lens material 55 is arranged in contact with the light-altering material 40 and the reflector wall 54, and the lens material 55 comprises an outwardly curved (convex) outer surface 56 through which light is extracted from the device 51. In certain embodiments, the lens material 55 comprises silicone. In certain embodiments, the lens material 55 is substantially CTE matched to the elevated reflector structure 52, and optionally may be substantially CTE matched to the remaining device layers (i.e., fill material layer 30, light-altering material layer 40, and second fill material layer 45), wherein in certain embodiments each of the foregoing items may comprise silicone (whether or not loaded with particulate material).

FIG. 3J shows a solid state light emitting device 61 including the solid state light subassembly 50 of FIG. 3F, following formation of a lens material 65 over the light-altering material layer 40 and the second fill material layer 45. A center portion of the lens material 65 has an outwardly curved (convex, partially hemispherical) shape, with flat extension portions 64 that extend over peripheral portions of the second fill material 45. In certain embodiments, the lens material 65 may be formed by molding over the solid state light-emitting assembly 50, and may comprise silicone (or another material that is substantially CTE matched with the fill material layer 30, the light-altering material layer 40, and the second fill material layer 30.

The inventor has observed that when using sealing templates described herein, in certain instances, a light-altering material (such as a lumiphoric material) applied through a window defined in a sealing template over an upper surface of a LED chip may result in a light-altering material having a peripheral portion with a reduced average thickness relative to an average thickness of a central portion of the light-altering material. Such an effect may be tailored by selecting and/or adjusting one or more of the following parameters during fabrication: method of deposition of light-altering material, directionality of deposition of light-altering material, viscosity of light-altering material, amount of light-altering material deposited, thickness of adhesive layer of sealing template, tack of adhesive layer of sealing template, undercut of adhesive layer of sealing template, surface energy of carrier layer of sealing template, and/or surface energy of fill material layer. A central portion of a light-altering material layer is arranged over an entirety of an outer surface of a LED chip, lateral edges surfaces of the LED chip are covered with a fill material (and devoid of the light-altering layer material), peripheral portions of the light-altering material layer are arranged over the fill material layer, and an average thickness of the peripheral portion of the light-altering material layer is less than an average thickness of the central portion of the light-altering material layer. In certain embodiments, the peripheral portion of the light-altering material layer comprises a non-uniform thickness, such as a thickness that declines with lateral distance away from the LED chip. In certain embodiments, a reflective material and/or a scattering material may be arranged in contact with lateral boundaries of the light-altering material, and a portion of the reflective and/or scattering material may overlap a reduced thickness (peripheral) portion of the light-altering material. In certain embodiments, the reflective and/or scattering material layer may comprise a maximum height substantially equal to a maximum height of the light-altering material. In certain embodiments, the light-altering material comprises a lumiphoric material.

FIGS. 4A-4F are simplified cross-sectional views depicting steps utilizing a sealing template in producing at least a portion of solid state light emitting device according to embodiments of the present invention, similar to the steps described in connection with FIGS. 3A-3F, but in which a solid state light emitting device portion or subassembly includes a lumiphoric material layer (or other light-altering material layer) having a reduced thickness at peripheral portions thereof, and in which portions of a second fill material layer contact and overlap peripheral portions of the lumiphoric material layer.

FIG. 4A illustrates a LED chip 16 mounted on a first (upper) surface 14 of a submount 12, with the LED chip 16 having a top or outer surface 18 (arranged distal from the first surface 14 of the submount 12) and having lateral edge surfaces 19. In certain embodiments, the LED chip 16 may have a flip-chip configuration.

FIG. 4B shows the items of FIG. 4A following addition of a layer of a (first) fill material 30 over the submount 12 to contact lateral edge surfaces 19 of the LED chip 16, with the top or outer surface 18 of the LED chip 16 remaining exposed. Lateral edge surfaces 19 of the LED chip 16 are devoid of lumiphoric material. According to the present invention, the fill material 30 comprises a reflective material, such as white (e.g., titanium dioxide or TiO₂) particles contained in a silicone binder. In certain embodiments, the fill material layer 30 includes a lower boundary 31 contacting the submount 12 and includes an upper boundary 32 arranged at substantially the same height or level as the top surface 18 of the LED chip 16, such that an upper boundary 32 of the fill material 30 may be substantially coplanar with the exposed outer surface 18 of the LED chip 16 to yield a continuous flat surface.

FIG. 4C shows the items of FIG. 4B following addition of a sealing template 35, which includes a carrier layer 36 and an adhesive layer 37, over the fill material layer 30. The sealing template 35 defines a window 38 (e.g., a precut window) that is larger than but generally aligned with the LED chip 16, wherein the window 38 also overlaps an LED-adjacent portion 32A of the fill material layer 30. In certain embodiments, the carrier layer 36 comprises a material that is transmissive of UV-spectrum emissions, and the adhesive layer 37 comprises a UV-release adhesive material. The top or outer surface 18 of the LED chip 16 is exposed through the window 38 defined in the sealing template 35.

FIG. 4D shows the items of FIG. 4C following application (using a deposition apparatus 39) of a lumiphoric material layer 40' (or other light-altering material layer) through the window 38 defined in the template 35 to be deposited on the top or outer surface 18 of the LED chip 16. As shown, the lumiphoric material layer 40' is arranged over the entire outer surface 18 of the LED chip and also overlaps the LED-adjacent top surface portion 32A of the fill material layer 30, so that the lumiphoric material layer 40' is wider than the top or outer surface 18 of the LED chip 16. Following application of the lumiphoric material layer 40', such material may be cured and solidified, such as with heat, electromagnetic radiation, and/or other means. After (or during) the curing of the light-altering material, UV emissions may be impinged on the sealing template 35 in order to reduce a tack of the adhesive layer 37. Thereafter, the sealing template 35 may be removed from the fill material 30 (e.g., by mechanical pulling).

FIG. 4E shows the items of FIG. 4D following removal of the sealing template 35, wherein a central portion 40A' of the lumiphoric material layer 40' overlaps the entire top or outer surface 18 of the LED chip 16, and peripheral portions 40B' of the lumiphoric material layer 40' overlap LED-adjacent top surface portions 32A of the fill material layer 30, while remaining top surface portions 32B of the fill material layer 30 are exposed. As shown, the central portion 40A' of the lumiphoric material layer 40' has a substantially constant thickness, whereas the peripheral portion 40B' of the lumiphoric material layer 40' has a thickness that reduces with lateral distance away from the LED chip 16. In this regard, the peripheral portion 40B' of the lumiphoric material layer 40' has an average thickness that is smaller than an average (and maximum) thickness of the central portion 40A' of the lumiphoric material layer 40', with a curved lateral edge or boundary 41' thereof.

FIG. 4F shows the items of FIG. 4E, following addition of a second fill material layer 45' to contact lateral edges or boundaries 41' of the lumiphoric material 40', and to contact the remaining top surface portions 32B of the first fill material layer 30, to yield a solid state light-emitting device portion or subassembly 50'. In certain embodiments, the second fill material layer 45' comprises a scattering material (such as fumed silica particles in a silicone binder) or a reflective material (e.g., titanium dioxide in a silicone binder). In certain embodiments, the second material layer 45' comprises a maximum height that is substantially identical to a maximum height of the lumiphoric material layer 40'. Proximate to the lateral edges or boundaries 41' of the lumiphoric material 40', the second fill material layer 45' comprises a variable thickness that increases with lateral distance away from the LED chip 16, to eventually comprise a constant thickness that is substantially equal to a maximum thickness of the lumiphoric material layer 40'. In certain embodiments, the second fill material layer 45' comprises substantially the same composition as the first fill material layer 30. In certain embodiments, the second fill material layer 45 and the first fill material layer 30 each comprise reflective material in a binder, wherein the first and second fill material layers 30, 45' may have the same or different reflectivity values. In certain embodiments, second fill material layer 45' comprises a scattering material in a binder (e.g., silicone) and the first fill material layer 30 comprises a reflective material in a binder (e.g., silicone). The second fill material layer 45' may serve to scatter and/or reflect light that escapes through lateral boundaries 41' of the lumiphoric material layer 40', such that in certain embodiments a desirable beam cutoff pattern and/or improved luminous efficacy may be provided. The solid state light-emitting subassembly 50' is suitable for forming of various solid state light-emitting devices that may include lenses contacting the lumiphoric material layer 40' (with or without an optional clear layer therebetween), wherein such lens may be optionally retained in reflector cavities of various sizes and shapes.

FIG. 4G shows a solid state light emitting device 51' including the solid state light emitting subassembly 50' with an elevated reflector structure 52 and lens material 55 thereon. The elevated reflector structure 52 includes an angled reflector wall 54 that bounds a reflector cavity 53. In certain embodiments, the elevated reflector structure 52 comprises reflective particles (e.g., titanium dioxide) in a silicone binder. In certain embodiments, a portion of the elevated reflector structure 52 may overlap peripheral portions of the lumiphoric material layer 40', preferably without overlapping the LED chip 16. The lens material 55 is arranged in contact with the lumiphoric material layer 40' and the reflector wall 54, and the lens material 55 comprises an outwardly curved (convex) outer surface 56 through which light is extracted from the device 51'. In certain embodiments, the lens material 55 comprises silicone. In certain embodiments, the lens material 55 is substantially CTE matched to the elevated reflector structure 52, and optionally may be substantially CTE matched to the remaining device layers (i.e., first fill material layer 30, lumiphoric material layer 40', and second fill material layer 45'), wherein in certain embodiments each of the foregoing items may comprise silicone (whether or not loaded with particulate material).

FIG. 4H shows a solid state light emitting device 61' including the solid state light subassembly 50' of FIG. 4F, following formation of a lens material 65 over the lumiphoric material layer 40' and the second fill material layer 45'. A center portion of the lens material 65 has an outwardly curved (convex, partially hemispherical) outer surface 66, with flat extension portions 64 that extend over peripheral portions of the second fill material 45'. In certain embodiments, the lens material 65 may be formed by molding over the solid state light-emitting assembly 50', and may comprise silicone (or another material that is substantially CTE matched with the first fill material layer 30, the lumiphoric material layer 40', and the second fill material layer 45', wherein the foregoing items may also include silicone with particulate material bound therein).

Although the preceding embodiments herein include fill material laterally bounding a light-altering (e.g., lumiphoric) material layer, the disclosure is not so limited. In certain embodiments, a solid state light-emitting device includes a light-altering material that is not laterally bounded by fill material contacting lateral edges of the light-altering material.

FIG. 5 illustrates a solid state light emitting device portion 46' according to an example not forming part of the present invention, including a light altering (e.g., lumiphoric) material layer 40 arranged over an upper surface 18 of a LED chip 16, and also over LED-adjacent upper surface portions 32A of a fill material layer 30 that contacts lateral edges surfaces 19 of the LED chip 16. The LED chip 16 and fill material layer 30 are supported by a submount 12. As shown, lateral edges or boundaries 41 of the light altering material layer 40 as well as remaining surface portions 32B of the fill material layer are exposed, without any contacting fill material thereon.

FIG. 6 illustrates a solid state light emitting device 71 according to an example not forming part of the present invention, a device portion similar to that shown in FIG. 5, overlaid with a cavity-defining reflector structure 72 and an outwardly curved lens material 65. A LED chip 16' is supported by a submount 12, with a fill material layer 30 also supported by the submount 12 being in contact with lateral edge surfaces 19' of the LED chip 16'. A lumiphoric (or other light-altering) material layer 40 extends over an entire outer surface of the LED chip 16', with a peripheral portion 40A of the lumiphoric material layer 40 also extending over LED-adjacent upper surface portions 32A' of the fill material layer 30. The cavity-defining reflector structure 72 is arranged over remaining surface portions 32B' of the fill material layer 30, defines an inclined reflector wall 74 that bounds a reflector cavity containing a part of the lens material 65, and further defines an upper surface 73. A center portion of the lens material 65 has an outwardly curved (convex, partially hemispherical) surface 66, with the lens material 65 further including flat extension portions 64 overlap the upper surface 73 of the reflector structure 72. In certain embodiments, the lens material 65 may be formed by molding over the reflector structure 72 and lumiphoric material layer 40, and may comprise silicone (or another material that is substantially CTE matched with the first fill material layer 30, the lumiphoric material layer 40, and the reflector structure 72, wherein the foregoing items may also comprise silicone with particulate material bound therein).

FIG. 7 provides a magnified view of the solid state light emitting device portion 50 of FIG. 3F, in which a lumiphoric material layer 40 is arranged over an upper surface 18 of a LED chip 16 and also over LED-adjacent upper surface portions 32A of a first fill material layer 30 that contacts lateral edge surfaces 19 of the LED chip 16. The LED chip 16 and fill material layer 30 are supported by a submount 12. A second fill material layer 45 is arranged over remaining portions 32B of the first fill material layer 30 and in contact with lateral edges 41 of the lumiphoric material layer 40, wherein the lumiphoric material layer 40 and the second fill material layer 45 provide a substantially flat upper surface suitable for depositing further items (e.g., reflector and/or lens structures) thereon.

FIG. 8 illustrates a solid state light emitting device according to an example not forming part of the present invention, incorporating the device portion of FIG. 7, including an elevated reflector structure 72' arranged over the second fill material layer 45, with the reflector structure defining a cavity filled with lens material 65. A center portion of the lens material 65 has an outwardly curved (convex, partially hemispherical) shape, with flat extension portions 64 that extend over a flat upper surface 73' of the elevated reflector structure 72' having a substantially hemispherical outer surface 66 and in contact with an inclined wall 74' of the elevated reflector structure 72'. The lens material 65 is also arranged in contact with the lumiphoric material layer 40. The lumiphoric material layer 40 is arranged over an upper surface 18 of a LED chip 16 and also over LED-adjacent upper surface portions 32A of a first fill material layer 30 that contacts lateral edge surfaces 19 of the LED chip 16, with such chip and first fill material layer 30 being supported by a submount 12. The second fill material layer 45 is arranged over remaining portions 32B of the first fill material layer 30 and in contact with lateral edges 41 of the lumiphoric material layer 40. In certain embodiments, all items of the light emitting device shown in FIG. 8 except for the LED chip and the submount may be substantially CTE-matched, such as by fabricating such items with silicone, optionally containing one or more particulate materials therein.

In certain embodiments, a sealing template may be elevated relative to a LED chip (e.g., with the LED chip optionally arranged in a cavity) during application of a light-altering material layer, wherein elevation of a sealing template, as well as size and shape of a window defined in the sealing template, may be used to affect a pattern and/or thickness profile (e.g., to provide a non-uniform thickness) of a light-altering material layer deposited on the LED chip.

FIG. 9A illustrates a solid state light emitting device including a LED chip 16 supported by a submount 12 and arranged in a cavity 153 defined by an elevated reflector structure 152, with a sealing template 135 (including a carrier layer 136 and an adhesive layer 137) defining a window arranged over the cavity 153. A first surface 14 of the submount 12 supports the LED chip 16 and a fill material layer 30, which contacts lateral side surfaces 19 of the LED chip 16. The elevated reflector structure 152 defines inclined cavity sidewalls 154 that, in combination with LED-adjacent upper surface portions 32A of the fill material layer 30, bound portions of the cavity 153. The elevated reflector structure extends over remaining upper surface portions 32B of the fill material layer 30. The sealing template 135 extends over an upper surface of the elevated reflector structure 152 and past the inclined cavity sidewalls to define a window (through which light affecting (e.g., lumiphoric) material 140 is supplied by a deposition apparatus 139 to be deposited over the LED chip 16 and LED-adjacent upper surface portions 32A of the fill material layer 30. The light affecting material 140 may have a non-uniform thickness profile over the LED chip 16. After deposition of the light affecting material 140, such material may be cured, the sealing template 135 may be treated with UV emissions to cause reduction or release of tack of the adhesive layer 137, and the sealing template 135 may be removed from the elevated reflector structure 152.

FIG. 9B illustrates the items of FIG. 9A, following removal of the sealing template, to yield a solid state light-emitting device 150, in which the light-altering material 140 on the LED chip 16 has a central portion 140A with an increased thickness, has a peripheral portions 140B with reduced thickness, and has a lateral boundary 141 that may or may not be arranged in contact with the inclined reflector sidewalls 154. The remaining items in FIG. 9B are the same as described above in connection with FIG. 9A.

Embodiments disclosed herein may provide one or more of the following beneficial technical effects: enabling fabrication of solid state light emitting devices with enhanced luminous efficacy and/or uniformity of color point over emissive area; simplifying fabrication of solid state light emitting devices; and enabling production of solid state light emitting devices with non-uniform layers of light-altering material.

Those skilled in the art will recognize improvements and modifications to the preferred embodiments of the present invention. All such improvements and modifications are considered within the scope of the present invention as defined by the claims that follow.

## Claims

1. A solid state light emitting device (51, 61), comprising:
at least one LED (16) mounted over a first surface (14) of a submount (12), with an outer surface (18) of the at least one LED (16) being distal from the first surface (14);
a lumiphoric material layer (40) comprising lumiphoric material, the lumiphoric material layer (40) comprising a central portion (40A') and a peripheral portion (40B'), the central portion (40A') of the lumiphoric material layer (40) being arranged over an entirety of the outer surface (18) of the at least one LED (16), wherein lateral edge surfaces (19) of the at least one LED (16) are devoid of lumiphoric material; and
a fill material layer (30) comprising fill material and contacting the lateral edge surfaces (19) of the at least one LED (16), the fill material comprising white or light-reflective particles dispersed in a binder;
wherein the peripheral portion (40B') of the lumiphoric material layer (40) is arranged over a portion of the fill material layer (30) in a region around a perimeter of the outer surface (18) of the at least one LED (16) and overlaps less than an entirety of the fill material layer (30), and
wherein an average thickness of the peripheral portion (40B') of the lumiphoric material layer (40) is less than an average thickness of the central portion (40A') of the lumiphoric material layer (40).

2. The solid state light emitting device (51, 61) of claim 1, further comprising a scattering material layer (45) contacting lateral boundaries of the lumiphoric material layer (40).

3. The solid state light emitting device (51, 61) of claim 2, wherein the scattering material layer (45) comprises a maximum height equal to a maximum height of the lumiphoric material layer (40).

4. The solid state light emitting device (51, 61) of claim 2, further comprising a lens material (55, 65) arranged in contact with the lumiphoric material layer (40) and at least a portion of the scattering material layer (45).

5. The solid state light emitting device (51, 61) of any one of claims 1 to 4, wherein the peripheral portion (40B') of the lumiphoric material layer (40) comprises a non-uniform thickness.

6. The solid state light emitting device (51, 61) of any one of claims 1 to 3, further comprising a lens material (55, 65) arranged in contact with the lumiphoric material layer (40) and overlying at least a portion of the fill material layer (30).

7. The solid state light emitting device (51, 61) of any one of claims 1 to 3, further comprising:
an elevated reflector structure (52) overlying at least a portion of the fill material layer (30), the elevated reflector structure (52) defining a reflector cavity (53) registered with the at least one LED (16); and
a lens material (55) arranged in the reflector cavity (53) and in contact with the lumiphoric material layer (40).

8. The solid state light emitting device (51, 61) of claim 7, wherein the lumiphoric material layer (40), the fill material layer (30), the elevated reflector structure (52), and the lens material (55) are matched in coefficient of thermal expansion (CTE), such that a difference in CTE between any two or more of the lumiphoric material layer (40), the fill material layer (30), the elevated reflector structure (52), and the lens material (55) is in a range of less than 20%.

9. A method for fabricating at least one solid state light emitting device (51, 61), the method comprising:
mounting at least one LED (16) over a first surface (14) of a submount (12) with an outer surface (18) of the at least one LED (16) being distal from the first surface (14);
applying a fill material (30) over the first surface (14) of the submount (12) to contact lateral edge surfaces (19) of the at least one LED (16), wherein the fill material (30) comprises white or reflective particles within a binder;
adhering a sealing template (35, 135) on or over the fill material (30), the sealing template (35, 135) comprising at least window (38) aligned with the at least one LED (16) and positioned to expose the outer surface (18) of the at least one LED (16);
applying a light-altering material through the at least one window (38) to the outer surface (18) of the at least one LED (16) to form a light-altering material layer (40, 140) thereon;
wherein the light-altering material comprises lumiphoric material;
wherein a central portion (40A', 140A) of the light-altering material layer (40, 140) is arranged over the entirety of the outer surface (18) of the at least one LED (16);
wherein a peripheral portion (40B', 140B) of the light-altering material layer (40, 140) is arranged over a portion of the fill material layer (30) in a region around a perimeter of the outer surface (18) of the at least one LED (16); and
wherein an average thickness of the peripheral portion (40B', 140B) of the light-altering material layer. (40, 140) is less than an average thickness of the central portion (40A', 140A) of the light-altering material layer (40, 140); and
removing the sealing template (35, 135) from the fill material (30).

10. The method of claim 9, wherein the sealing template (35, 135) comprises an ultraviolet release adhesive layer. (37, 137) and a carrier (36, 136), and the method further comprises impinging ultraviolet emissions on the sealing template (35, 135) to reduce a tack of the ultraviolet release adhesive layer (37, 137) prior to said removing of the sealing template (35, 135) from the fill material (30).

11. The method of any one of claims 9 or 10, wherein the fill material (30) is applied over the first surface (14) of the submount (12) by at least one process selected from the group consisting of (a) jet pumping, (b) stencil printing, (c) screen printing, (d) dispensing, and (e) spraying.

12. The method of any one of claims 9 to 11, wherein:
an area of at least one window (38) is larger than an area of the outer surface (18) of the at least one LED (16); and
the applying of the light-altering material through the at least one window (38) to the outer surface (18) of the at least one LED (16) causes a portion of the light-altering material to contact the fill material (30) in a region outside a perimeter of the outer surface (18) of the at least one LED (16).

13. The method of any one of claims 9 to 12, wherein:
the sealing template (35, 135) is applied over an intermediate layer that is elevated relative to the fill material (30); and
the light-altering material is applied through the at least one window (38) to the outer surface (18) of the at least one LED (16) by spraying;
optionally wherein the light-altering material is applied to the outer surface (18) of the at least one LED (16) to provide a light-altering material layer thickness that varies with position along the outer surface (18) of the at least one LED (16).

14. The method of claim 9, further comprising, after the removing of the sealing template (35), applying a light-scattering (45) or light-absorbing material layer over the fill material (30) to contact lateral boundaries of the light-altering material layer (40).

## Patentansprüche

1. Festkörper-Lichtemissionsvorrichtung (51, 61), umfassend:
mindestens eine LED (16), die über einer ersten Oberfläche (14) eines Submounts (12) angebracht ist, wobei eine Außenfläche (18) der mindestens einen LED (16) von der ersten Oberfläche (14) entfernt ist;
eine Luminophor-Materialschicht (40), die Luminophor-Material umfasst, wobei die Luminophor-Materialschicht (40) einen zentralen Abschnitt (40A') und einen peripheren Abschnitt (40B') umfasst, wobei der zentrale Abschnitt (40A') der Luminophor-Materialschicht (40) über der gesamten Außenfläche (18) der mindestens einen LED (16) angeordnet ist, wobei seitliche Kantenflächen (19) der mindestens einen LED (16) frei von Luminophor-Material sind; und
eine Füllmaterialschicht (30), die Füllmaterial umfasst und mit den seitlichen Kantenflächen (19) der mindestens einen LED (16) in Kontakt steht, wobei das Füllmaterial weiße oder lichtreflektierende Partikel umfasst, die in einem Bindemittel dispergiert sind;
wobei der periphere Abschnitt (40B') der Luminophor-Materialschicht (40) über einem Abschnitt der Füllmaterialschicht (30) in einem Bereich um den Umfang der Außenfläche (18) der mindestens einen LED (16) angeordnet ist und weniger als die gesamte Füllmaterialschicht (30) überlappt, und
wobei die durchschnittliche Dicke des peripheren Abschnitts (40B') der Luminophor-Materialschicht (40) geringer ist als die durchschnittliche Dicke des zentralen Abschnitts (40A') der Luminophor-Materialschicht (40).

2. Festkörper-Lichtemissionsvorrichtung (51, 61) nach Anspruch 1, weiter umfassend eine Streumaterialschicht (45), die mit den seitlichen Grenzen der Luminophor-Materialschicht (40) in Kontakt steht.

3. Festkörper-Lichtemissionsvorrichtung (51, 61) nach Anspruch 2, wobei die Streumaterialschicht (45) eine maximale Höhe umfasst, die der maximalen Höhe der Luminophor-Materialschicht (40) entspricht.

4. Festkörper-Lichtemissionsvorrichtung (51, 61) nach Anspruch 2, weiter umfassend ein Linsenmaterial (55, 65), das in Kontakt mit der Luminophor-Materialschicht (40) und mindestens einem Teil der Streumaterialschicht (45) angeordnet ist.

5. Festkörper-Lichtemissionsvorrichtung (51, 61) nach einem der Ansprüche 1 bis 4, wobei der periphere Abschnitt (40B') der Luminophor-Materialschicht (40) eine ungleichmäßige Dicke umfasst.

6. Festkörper-Lichtemissionsvorrichtung (51, 61) nach einem der Ansprüche 1 bis 3, weiter umfassend ein Linsenmaterial (55, 65), das in Kontakt mit der Luminophor-Materialschicht (40) angeordnet ist und mindestens einen Abschnitt der Füllmaterialschicht (30) bedeckt.

7. Festkörper-Lichtemissionsvorrichtung (51, 61) nach einem der Ansprüche 1 bis 3, weiter umfassend:
eine erhöhte Reflektorstruktur (52), die zumindest einen Abschnitt der Füllmaterialschicht (30) bedeckt, wobei die erhöhte Reflektorstruktur (52) einen Reflektorhohlraum (53) definiert, der mit der mindestens einen **LED** (16) fluchtet; und
ein Linsenmaterial (55), das im Reflektorhohlraum (53) angeordnet ist und mit der Luminophor-Materialschicht (40) in Kontakt steht.

8. Festkörper-Lichtemissionsvorrichtung (51, 61) nach Anspruch 7, wobei die Luminophor-Materialschicht (40), die Füllmaterialschicht (30), die erhöhte Reflektorstruktur (52) und das Linsenmaterial (55) in ihrem Wärmeausdehnungskoeffizienten (CTE) aufeinander abgestimmt sind, sodass die Differenz im CTE zwischen jeweils zwei oder mehreren der Luminophor-Materialschicht (40), der Füllmaterialschicht (30), der erhöhten Reflektorstruktur (52) und dem Linsenmaterial (55) in einem Bereich von weniger als 20 % liegt.

9. Verfahren zur Herstellung mindestens einer Festkörper-Lichtemissionsvorrichtung (51, 61), wobei das Verfahren Folgendes umfasst:
Anbringen mindestens einer LED (16) über einer ersten Oberfläche (14) eines Submounts (12), wobei eine Außenfläche (18) der mindestens einen LED (16) von der ersten Oberfläche (14) entfernt ist;
Aufbringen eines Füllmaterials (30) auf die erste Oberfläche (14) des Submounts (12), sodass es mit den seitlichen Kantenflächen (19) der mindestens einen LED (16) in Kontakt steht, wobei das Füllmaterial (30) weiße oder reflektierende Partikel in einem Bindemittel umfasst;
Befestigen einer Dichtungsschablone (35, 135) auf oder über das Füllmaterial (30), wobei die Dichtungsschablone (35, 135) mindestens ein Fenster (38) umfasst, das auf die mindestens eine LED (16) ausgerichtet und so positioniert ist, dass die Außenfläche (18) der mindestens einen LED (16) freigelegt ist;
Aufbringen eines lichtverändernden Materials durch das mindestens eine Fenster (38) auf die Außenfläche (18) der mindestens einen LED (16), um darauf eine lichtverändernde Materialschicht (40, 140) zu bilden;
wobei das lichtverändernde Material ein Luminophor-Material umfasst;
wobei ein zentraler Abschnitt (40A', 140A) der lichtverändernden Materialschicht (40, 140) über der gesamten Außenfläche (18) der mindestens einen LED (16) angeordnet ist;
wobei ein peripherer Abschnitt (40B', 140B) der lichtverändernden Materialschicht (40, 140) über einem Abschnitt der Füllmaterialschicht (30) in einem Bereich um den Umfang der Außenfläche (18) der mindestens einen LED (16) angeordnet ist; und
wobei die durchschnittliche Dicke des peripheren Abschnitts (40B', 140B) der lichtverändernden Materialschicht (40, 140) geringer ist als die durchschnittliche Dicke des zentralen Abschnitts (40A', 140A) der lichtverändernden Materialschicht (40, 140); und
Entfernen der Dichtungsschablone (35, 135) von dem Füllmaterial (30).

10. Verfahren nach Anspruch 9, wobei die Dichtungsschablone (35, 135) eine UVablösbare Klebeschicht (37, 137) und einen Träger (36, 136) umfasst, und das Verfahren ferner das Bestrahlen der Dichtungsschablone (35, 135) mit ultravioletter Strahlung umfasst, um die Klebkraft der UV-ablösbaren Klebeschicht (37, 137) vor dem Entfernen der Dichtungsschablone (35, 135) vom Füllmaterial (30) zu verringern.

11. Verfahren nach einem der Ansprüche 9 oder 10, wobei das Füllmaterial (30) durch mindestens ein Verfahren, das aus der Gruppe ausgewählt ist, die aus (a) Strahlpumpen, (b) Schablonendruck, (c) Siebdruck, (d) Dosieren und (e) Sprühen besteht, auf die erste Oberfläche (14) des Submounts (12) aufgebracht wird.

12. Verfahren nach einem der Ansprüche 9 bis 11, wobei:
ein Bereich mindestens eines Fensters (38) größer ist als ein Bereich der Außenfläche (18) der mindestens einen LED (16); und
das Aufbringen des lichtverändernden Materials durch das mindestens eine Fenster (38) auf die Außenfläche (18) der mindestens einen LED (16) bewirkt, dass ein Abschnitt des lichtverändernden Materials in einem Bereich außerhalb des Umfangs der Außenfläche (18) der mindestens einen LED (16) mit dem Füllmaterial (30) in Kontakt steht.

13. Verfahren nach einem der Ansprüche 9 bis 12, wobei:
die Dichtungsschablone (35, 135) über eine Zwischenschicht angebracht wird, die relativ zum Füllmaterial (30) erhöht ist; und
das lichtverändernde Material durch das mindestens eine Fenster (38) mittels Sprühen auf die Außenfläche (18) der mindestens einen LED (16) aufgebracht wird;
gegebenenfalls wobei das lichtverändernde Material auf die Außenfläche (18) der mindestens einen LED (16) aufgebracht wird, um eine Schichtdicke des lichtverändernden Materials bereitzustellen, die entlang der Außenfläche (18) der mindestens einen LED (16) je nach Position variiert.

14. Verfahren nach Anspruch 9,
weiter umfassend, dass nach dem Entfernen der Dichtungsschablone (35) eine lichtstreuende (45) oder lichtabsorbierende Materialschicht auf das Füllmaterial (30) aufgebracht wird, sodass sie mit den seitlichen Grenzen der lichtverändernden Materialschicht (40) in Kontakt steht.

## Revendications

1. Dispositif électroluminescent à semi-conducteurs (51, 61), comprenant :
au moins une LED (16) montée par-dessus une première surface (14) d'une embase (12), avec une surface externe (18) de l'au moins une LED (16) qui est distale par rapport à la première surface (14) ;
une couche de matériau luminophore (40) comprenant un matériau luminophore, la couche de matériau luminophore (40) comprenant une partie centrale (40A') et une partie périphérique (40B'), la partie centrale (40A') de la couche de matériau luminophore (40) étant agencée par-dessus une totalité de la surface externe (18) de l'au moins une LED (16), dans lequel des surfaces de bords latéraux (19) de l'au moins une LED (16) sont dépourvues de matériau luminophore ; et
une couche de matériau de remplissage (30) comprenant un matériau de remplissage et entrant en contact avec les surfaces de bords latéraux (19) de l'au moins une LED (16), le matériau de remplissage comprenant des particules blanches ou réfléchissant la lumière dispersées dans un liant ;
dans lequel la partie périphérique (40B') de la couche de matériau luminophore (40) est agencée par-dessus une partie de la couche de matériau de remplissage (30) dans une région autour d'un périmètre de la surface externe (18) de l'au moins une LED (16) et chevauche moins qu'une totalité de la couche de matériau de remplissage (30), et
dans lequel une épaisseur moyenne de la partie périphérique (40B') de la couche de matériau luminophore (40) est inférieure à une épaisseur moyenne de la partie centrale (40A') de la couche de matériau luminophore (40).

2. Dispositif électroluminescent à semi-conducteurs (51, 61) selon la revendication 1, comprenant en outre une couche de matériau de diffusion (45) entrant en contact avec des frontières latérales de la couche de matériau luminophore (40).

3. Dispositif électroluminescent à semi-conducteurs (51, 61) selon la revendication 2, dans lequel la couche de matériau de diffusion (45) comprend une hauteur maximum égale à une hauteur maximum de la couche de matériau luminophore (40).

4. Dispositif électroluminescent à semi-conducteurs (51, 61) selon la revendication 2, comprenant en outre un matériau de lentille (55, 65) agencé en contact avec la couche de matériau luminophore (40) et au moins une partie de la couche de matériau de diffusion (45).

5. Dispositif électroluminescent à semi-conducteurs (51, 61) selon l'une quelconque des revendications 1 à 4, dans lequel la partie périphérique (40B') de la couche de matériau luminophore (40) comprend une épaisseur non uniforme.

6. Dispositif électroluminescent à semi-conducteurs (51, 61) selon l'une quelconque des revendications 1 à 3, comprenant en outre un matériau de lentille (55, 65) agencé en contact avec la couche de matériau luminophore (40) et se superposant à au moins une partie de la couche de matériau de remplissage (30).

7. Dispositif électroluminescent à semi-conducteurs (51, 61) selon l'une quelconque des revendications 1 à 3, comprenant en outre :
une structure réfléchissante élevée (52) se superposant à au moins une partie de la couche de matériau de remplissage (30), la structure réfléchissante élevée (52) définissant une cavité réfléchissante (53) alignée avec l'au moins une LED (16) ; et
un matériau de lentille (55) agencé dans la cavité réfléchissante (53) et en contact avec la couche de matériau luminophore (40).

8. Dispositif électroluminescent à semi-conducteurs (51, 61) selon la revendication 7, dans lequel la couche de matériau luminophore (40), la couche de matériau de remplissage (30), la structure réfléchissante élevée (52) et le matériau de lentille (55) présentent un coefficient de dilatation thermique compatible (CTE), de telle sorte qu'une différence de CTE entre l'un quelconque de deux ou plus de la couche de matériau luminophore (40), de la couche de matériau de remplissage (30), de la structure réfléchissante élevée (52) et du matériau de lentille (55) se situe dans une plage inférieure à 20 %.

9. Procédé destiné à fabriquer au moins un dispositif électroluminescent à semi-conducteurs (51, 61), le procédé comprenant :
le montage d'au moins une LED (16) par-dessus une première surface (14) d'une embase (12) avec une surface externe (18) de l'au moins une LED (16) qui est distale par rapport à la première surface (14) ;
l'application d'un matériau de remplissage (30) par-dessus la première surface (14) de l'embase (12) pour entrer en contact avec des surfaces de bords latéraux (19) de l'au moins une LED (16), dans lequel le matériau de remplissage (30) comprend des particules blanches ou réfléchissantes au sein d'un liant ;
l'adhérence d'un gabarit d'étanchéité (35, 135) sur ou par-dessus le matériau de remplissage (30), le gabarit d'étanchéité (35, 135) comprenant au moins une fenêtre (38) alignée avec l'au moins une LED (16) et positionnée pour exposer la surface externe (18) de l'au moins une LED (16) ;
l'application d'un matériau modifiant la lumière à travers l'au moins une fenêtre (38) sur la surface externe (18) de l'au moins une LED (16) pour former une couche de matériau modifiant la lumière (40, 140) sur celle-ci ;
dans lequel le matériau modifiant la lumière comprend un matériau luminophore ;
dans lequel une partie centrale (40A', 140A') de la couche de matériau modifiant la lumière (40, 140) est agencée par-dessus la totalité de la surface externe (18) de l'au moins une LED (16) ;
dans lequel une partie périphérique (40B', 140B) de la couche de matériau modifiant la lumière (40, 140) est agencée par-dessus une partie de la couche de matériau de remplissage (30) dans une région autour d'un périmètre de la surface externe (18) de l'au moins une LED (16) ; et
dans lequel une épaisseur moyenne de la partie périphérique (40B', 140B) de la couche de matériau modifiant la lumière (40, 140) est inférieure à une épaisseur moyenne de la partie centrale (40', 140A) de la couche de matériau modifiant la lumière (40, 140) ; et
le retrait du gabarit d'étanchéité (35, 135) du matériau de remplissage (30).

10. Procédé selon la revendication 9, dans lequel le gabarit d'étanchéité (35, 135) comprend une couche adhésive à libération d'ultraviolets (37, 137) et un support (36, 136) et le procédé comprend en outre la projection d'émissions d'ultraviolets sur le gabarit d'étanchéité (35, 135) pour réduire une adhérence de la couche adhésive à libération d'ultraviolets (37, 137) avant ledit retrait du gabarit d'étanchéité (35, 135) du matériau de remplissage (30).

11. Procédé selon l'une quelconque des revendications 9 ou 10, dans lequel le matériau de remplissage (30) est appliqué par-dessus la première surface (14) de l'embase (12) par au moins un processus sélectionné à partir du groupe constitué (a) d'un pompage à jet, (b) d'une impression au pochoir, (c) d'une sérigraphie, (d) d'une distribution et (e) d'une pulvérisation.

12. Procédé selon l'une quelconque des revendications 9 à 11, dans lequel :
une zone d'au moins une fenêtre (38) est supérieure à une zone de la surface externe (18) de l'au moins une LED (16) ; et
l'application du matériau modifiant la lumière à travers l'au moins une fenêtre (38) sur la surface externe (18) de l'au moins une LED (16) amène une partie du matériau modifiant la lumière à entrer en contact avec le matériau de remplissage (30) dans une région à l'extérieur d'un périmètre de la surface externe (18) de l'au moins une LED (16).

13. Procédé selon l'une quelconque des revendications 9 à 12, dans lequel :
le gabarit d'étanchéité (35, 135) est appliqué par-dessus une couche intermédiaire qui est élevée par rapport au matériau de remplissage (30) ; et
le matériau modifiant la lumière est appliqué à travers l'au moins une fenêtre (38) sur la surface externe (18) de l'au moins une LED (16) par pulvérisation ;
facultativement dans lequel le matériau modifiant la lumière est appliqué sur la surface externe (18) de l'au moins une LED (16) pour fournir une épaisseur de couche de matériau modifiant la lumière qui varie en fonction de la position le long de la surface externe (18) de l'au moins une LED (16).

14. Procédé selon la revendication 9,
comprenant en outre, après le retrait du gabarit d'étanchéité (35), l'application d'une couche de matériau diffusant la lumière (45) ou absorbant la lumière par-dessus le matériau de remplissage (30) pour entrer en contact avec des frontières latérales de la couche de matériau modifiant la lumière (40).
